# EUROPEAN PATENT APPLICATION

(11) **EP 4 081 007 A1**
(43) Date of publication of application: **26.10.2022**
(21) Application number: 20913987.2
(22) Date of filing: 15.12.2020
(51) Int. Cl.: H05K 7/20

(54) **CHIP, PRODUCING METHOD THEREFOR, AND ELECTRONIC DEVICE**

(30) Priority: 13.01.2020 CN 202010030157
(71) Applicant: Huawei Technologies Co., Ltd., Shenzhen, Guangdong 518129 (CN)
(72) Inventor: DENG, Chaojun, Shenzhen, Guangdong 518129 (CN)
(74) Representative: Körber, Martin Hans
(86) International application number: PCT/CN2020/136507
(87) International publication number: WO 2021/143429

(57) **Abstract**

A chip, a method for manufacturing a chip, and an electronic device are disclosed, and belong to the field of chip heat dissipation technologies. The chip includes a housing (1), a plurality of silicon wafers (2), and a plurality of thermal pads (3). The plurality of silicon wafers (2) and the plurality of thermal pads (3) are mounted in the housing (1) in a stacked manner. The thermal pad (3) is mounted between two adjacent silicon wafers (2), and an edge of the thermal pad (3) extends from a gap between the two adjacent silicon wafers (2). The thermal pad (3) is mounted between the two adjacent silicon wafers (2), so that heat on the silicon wafer (2) may be conducted to the thermal pad (3), to reduce a temperature on the silicon wafer (2) and improve a heat dissipation capability of the chip, so as to avoid a case in which the chip is burnt out because a large amount of heat accumulates on the silicon wafer (2).

## Description

This application claims priority to Chinese Patent Application No. 202010030157.4, filed on January 13, 2020 and entitled "CHIP, METHOD FOR MANUFACTURING CHIP, AND ELECTRONIC DEVICE", which is incorporated herein by reference in its entirety.

### TECHNICAL FIELD

This application relates to the field of chip heat dissipation technologies, and in particular, to a chip, a method for manufacturing a chip, and an electronic device.

### BACKGROUND

With development of chip technologies, a multi-silicon wafer stacking technology is an important trend in development of the field of chip technologies. The multi-silicon wafer stacking technology means that a chip includes a plurality of silicon wafers, and the plurality of silicon wafers are stacked from top to bottom in a housing of the chip.

A substrate made of epoxy resin is disposed at a bottom of the housing of the chip. The substrate has relatively poor thermal conductivity, and there is a relatively small heat dissipation area on a side part of the housing due to a flat shape of the chip. An upper cover of the housing is made of metal with thermal conductivity. In this way, heat generated by the silicon wafer mounted in the housing may be dissipated to the outside by using the upper cover of the housing.

However, when heat dissipation is performed for the chip by using the upper cover of the housing, it is difficult to dissipate heat generated by a silicon wafer close to the bottom of the housing, a relatively high temperature accumulates, and consequently the chip is burnt out.

### SUMMARY

Embodiments of this application provide a chip, a method for manufacturing a chip, and an electronic device, to resolve a problem, in a related technology, that it is difficult to dissipate heat generated by a silicon wafer close to a bottom of a housing, a relatively high temperature accumulates, and consequently a chip is burnt out. The technical solutions are as follows:

According to an aspect, a chip is provided. The chip includes a housing, a plurality of silicon wafers, and a plurality of thermal pads. The plurality of silicon wafers and the plurality of thermal pads are mounted in the housing in a stacked manner. The thermal pad is mounted between two adjacent silicon wafers, and an edge of the thermal pad extends from a gap between the two adjacent silicon wafers.

The thermal pad is made of a material with a relatively high coefficient of thermal conductivity. To prevent the thermal pad from affecting a circuit on the silicon wafer and electrical connection between adjacent silicon wafers, the thermal pad is an insulating thermal pad, in other words, the thermal pad has an insulating property and is thermally conductive.

In the solution shown in this embodiment of this application, the housing of the chip may include a bottom, a side part, and an upper cover, and the plurality of silicon wafers and the plurality of thermal pads are mounted in the housing in the stacked manner. For example, the plurality of silicon wafers and the plurality of thermal pads are sequentially and alternately disposed from the bottom to the upper cover in the housing. Further, the silicon wafer is sandwiched between two adjacent thermal pads, the thermal pad is sandwiched between the two adjacent silicon wafers, and the edge of the thermal pad may extend from the gap between the two adjacent silicon wafers.

Based on the foregoing structure, heat generated by the silicon wafer is transferred to the thermal pad in contact with the silicon wafer. A coefficient of thermal conductivity of the thermal pad is greater than a coefficient of thermal conductivity of the silicon wafer, and therefore the heat on the silicon wafer can be quickly transferred to the thermal pad, to reduce a temperature on the silicon wafer. The edge of the thermal pad may extend from the gap between the two adjacent silicon wafers, and therefore an area of the thermal pad is greater than an area of the silicon wafer, and heat absorbed by the thermal pad may be diffused on the thermal pad, so that the heat is evenly distributed, to avoid heat accumulation. It may be learned that based on the foregoing feature, a heat dissipation capability of the chip may be improved, and therefore a case in which the chip is burnt out because a large amount of heat accumulates on the silicon wafer may be avoided.

In a possible implementation, a thermally conductive layer is filled between two adjacent thermal pads and between a thermal pad close to the upper cover of the housing and the upper cover.

The thermally conductive layer may be made of a thermally conductive silica gel material.

In the solution shown in this embodiment of this application, the two adjacent thermal pads are connected by using the thermally conductive layer, and a thermal pad located at an uppermost layer is connected to the upper cover. In this way, the thermal pad can relatively quickly transfer heat to the upper cover of the housing, to dissipate the heat to the outside by using the upper cover, so as to improve the heat dissipation capability of the chip.

In a possible implementation, each thermal pad is connected to the upper cover of the housing by using a thermal conductor. For example, each thermal pad is connected to the upper cover of the housing by using a copper pillar.

In the solution shown in this embodiment of this application, the upper cover of the housing has a heat dissipation capability. In this way, the heat generated by the silicon wafer is transferred to the thermal pad with a relatively large area, to reduce the temperature on the silicon wafer. Each thermal pad transfers heat upwards to the upper cover of the housing by using the thermal conductor connected to the thermal pad, to dissipate the heat to the outside by using the upper cover of the housing. In this way, heat absorbed by each thermal pad from a silicon wafer in contact with the thermal pad can be quickly transferred to the upper cover, and is dissipated to the outside by using the upper cover, to improve the heat dissipation capability of the chip.

In a possible implementation, the thermal pad is mounted between the bottom of the housing and a silicon wafer close to the bottom.

In the solution shown in this embodiment of this application, the thermal pad is mounted between the bottom of the housing and the silicon wafer close to the bottom, and the thermal pad located at the bottom can dissipate heat for the silicon wafer close to the bottom, to avoid a phenomenon of temperature accumulation on the silicon wafer located at the bottom.

In a possible implementation, the thermal pad is mounted between the upper cover of the housing and a silicon wafer close to the upper cover.

In the solution shown in this embodiment of this application, the thermal pad is mounted between the upper cover of the housing and the silicon wafer close to the upper cover, so that the thermal pad located at a top can quickly transfer heat to the upper cover, to dissipate the heat to the outside by using the upper cover, and a temperature on a thermal pad at a lower part can be quickly transferred to the thermal pad at the top by using a copper pillar or a thermally conductive layer, to further improve the heat dissipation capability of the chip.

In a possible implementation, the two adjacent silicon wafers are connected by using a copper pillar, and the thermal pad is provided with a through hole configured to avoid the copper pillar.

Two adjacent chips may be electrically connected by using the copper pillar. In addition, copper has relatively high thermal conductivity, and therefore the heat dissipation capability of the chip can be further improved.

There is the copper pillar between the two adjacent silicon wafers. Therefore, to avoid the copper pillar, correspondingly, the through hole configured to avoid the copper pillar is disposed on the thermal pad. In this way, the thermal pad is sandwiched between the two adjacent silicon wafers, and the copper pillar between the two adjacent silicon wafers passes through the through hole on the thermal pad.

In this way, the chip transfers heat upwards to the upper cover by using the copper pillar in a vertical direction, to dissipate the heat to the outside by using the upper cover. For the chip, in a horizontal direction, the coefficient of thermal conductivity of the thermal pad is greater than the coefficient of thermal conductivity of the silicon wafer, and therefore the heat generated by the silicon wafer can be relatively quickly transferred to the thermal pad. In addition, the area of the thermal pad is greater than the area of the silicon wafer, and therefore heat on the thermal pad may be diffused on the thermal pad, so that the heat is evenly distributed on the thermal pad, to facilitate reduction of a temperature on the chip. It may be learned that the heat generated by the silicon wafer may be dissipated upwards by using the copper pillar and transferred to the upper cover of the housing, and the heat generated by the silicon wafer may be further absorbed by the thermal pad in contact with the silicon wafer. Therefore, heat dissipation performance of the chip may be improved, and a case in which a relatively large amount of heat accumulates in the chip may be avoided, to protect the chip.

In a possible implementation, the upper cover of the housing and the thermal pad are made of a same material.

In the solution shown in this embodiment of this application, each of the upper cover of the housing and the thermal pad is made of a material with a relatively high coefficient of thermal conductivity, and the upper cover of the housing and the thermal pad may be made of the same material. For example, each of the upper cover of the housing and the thermal pad may be one or more of a single crystal diamond film, a polycrystalline diamond film, or a boron nitride film. In this way, both the upper cover and the thermal pad have relatively high thermal conductivity, and therefore the heat dissipation capability of the chip may be improved.

In a possible implementation, the thermal pad is one or more of a single crystal diamond film, a polycrystalline diamond film, and a boron nitride film.

In the solution shown in this embodiment of this application, the thermal pad is added between the two adjacent silicon wafers in the chip, to accelerate heat dissipation for the chip and improve the heat dissipation capability of the chip. Therefore, the thermal pad is made of a material with relatively high thermal conductivity. To avoid affecting the circuit on the silicon wafer, the thermal pad is made of an insulating material. Therefore, the thermal pad is made of an insulating and thermally conductive material. Each of the single crystal diamond film, the polycrystalline diamond film, and the boron nitride film is an insulating and thermally conductive material, and therefore the thermal pad is one or more of the single crystal diamond film, the polycrystalline diamond film, and the boron nitride film.

According to another aspect, an embodiment of this application further provides a method for manufacturing a chip. First, a plurality of silicon wafers and a plurality of thermal pads may be fastened in a stacked manner. For example, the silicon wafer and the thermal pad may be fastened by using a copper pillar. At least one thermal pad is mounted between two adjacent silicon wafers, and an edge of the thermal pad extends from a gap between the two adjacent silicon wafers. Then, the fastened silicon wafers and thermal pads may be mounted in a housing 1, to obtain the chip.

According to another aspect, an embodiment of this application further provides an electronic device. The electronic device may be a mobile terminal such as a mobile phone and a tablet computer, may be a computer device, or may be another electronic device that includes a chip. The electronic device may include at least one chip described above. For example, the included chip may be a chip in a processor of the electronic device, or may be a chip in a processor of the electronic device.

In some embodiments, a size of the thermal pad is greater than a size of the silicon wafer.

The technical solution provided in embodiments of this application brings at least the following beneficial effects:

In embodiments of this application, the chip includes the housing and the plurality of silicon wafers and the plurality of thermal pads mounted in the housing in the stacked manner, and the thermal pad is mounted between the two adjacent silicon wafers. The coefficient of thermal conductivity of the thermal pad is greater than the coefficient of thermal conductivity of the silicon wafer, and therefore the heat generated by the silicon wafer may be transferred to the thermal pad in contact with the silicon wafer, to reduce the temperature on the silicon wafer. The edge of the thermal pad may extend from the gap between the two adjacent silicon wafers, and therefore the heat absorbed by the thermal pad may be diffused on the thermal pad, so that a temperature on the thermal pad is evenly distributed, to avoid heat accumulation. It may be learned that the thermal pad is mounted between the two adjacent silicon wafers, so that the heat on the silicon wafer may be quickly conducted to the thermal pad, to reduce the temperature on the silicon wafer and improve the heat dissipation capability of the chip, so as to avoid a case in which the chip is burnt out because a large amount of heat accumulates on the silicon wafer.

### BRIEF DESCRIPTION OF DRAWINGS

FIG. 1 is a schematic diagram of a structure of a chip according to an embodiment of this application;
FIG. 2 is a schematic diagram of a structure of a chip according to an embodiment of this application;
FIG. 3 is a schematic diagram of a structure of a chip according to an embodiment of this application;
FIG. 4 is a schematic diagram of a structure of a chip according to an embodiment of this application; and
FIG. 5 is a schematic diagram of a structure of a chip according to an embodiment of this application.

Legend description:
1: Housing; 2: Silicon wafer; 3: Thermal pad; and 31: Through hole.

### DESCRIPTION OF EMBODIMENTS

An embodiment of this application provides a chip. The chip may be a chip in an electronic device. For example, the chip may be a chip in a processor of the electronic device, or may be a chip in a memory of the electronic device.

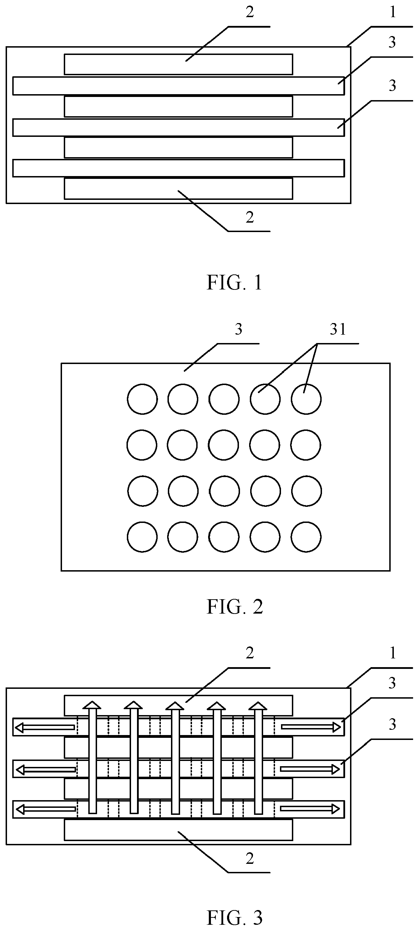

FIG. 1 is a cross-sectional schematic diagram of a structure of the chip. The chip includes a housing 1, a plurality of silicon wafers 2, and a plurality of thermal pads 3. The plurality of silicon wafers 2 and the plurality of thermal pads 3 are mounted in the housing 1 in a stacked manner. The thermal pad 3 is mounted between two adjacent silicon wafers 2, and an edge of the thermal pad 3 extends from a gap between the two adjacent silicon wafers 2.

A coefficient of thermal conductivity of the thermal pad 3 is greater than a coefficient of thermal conductivity of the silicon wafer. To prevent the thermal pad 3 from affecting a circuit on the silicon wafer 2 and electrical connection between adjacent silicon wafers 2, the thermal pad 3 is an insulating thermal pad, in other words, the thermal pad 3 has an insulating property and is thermally conductive. For example, the thermal pad 3 may be one or more of a single crystal diamond film, a polycrystalline diamond film, or a boron nitride film.

For example, all of the thermal pads 3 may be single crystal diamond films, polycrystalline diamond films, or boron nitride films; some of the thermal pads 3 may be single crystal diamond films, and the other thermal pads 3 may be polycrystalline diamond films; or some of the thermal pads 3 may be single crystal diamond films, some of the thermal pads 3 may be polycrystalline diamond films, and the other thermal pads 3 may be boron nitride films.

In this embodiment, a specific material of the thermal pad 3 is not limited, provided that the thermal pad 3 has a coefficient of thermal conductivity greater than the coefficient of thermal conductivity of the silicon wafer, and has an insulating property.

In an example, the housing of the chip may include a bottom, a side part, and an upper cover. A substrate made of epoxy resin is usually disposed at the bottom of the housing 1 of the chip, and the substrate has relatively poor thermal conductivity. The chip is usually of a flat structure. The side part of the chip has a relatively small height and a small area, and therefore the side part has a relatively poor heat dissipation effect. The upper cover of the housing 1 is usually made of a metal with relatively high thermal conductivity, for example, copper or aluminum. Therefore, the chip usually dissipates heat to the outside by using the upper cover of the housing 1.

As described above, the edge of the thermal pad 3 extends from the gap between the two adjacent silicon wafers 2. For example, both the thermal pad 3 and the silicon wafer 2 may be in a round shape, and a radius of the thermal pad 3 is greater than a radius of the silicon wafer 2, so that the edge of the thermal pad 3 may extend from the gap between the two adjacent silicon wafers 2. For another example, both the thermal pad 3 and the silicon wafer 2 may be in a rectangular shape, a length of the thermal pad 3 is greater than a length of the silicon wafer 2, and a width of the thermal pad 3 is greater than a width of the silicon wafer 2, so that the edge of the thermal pad 3 may extend from the gap between the two adjacent silicon wafers 2.

The edge of the thermal pad 3 extends from the gap between the two adjacent silicon wafers 2, so that the entire silicon wafer 2 may be in contact with the thermal pad 3. Further, when the chip works, even if a relatively large amount of heat is generated at a local position of the silicon wafer 2, and temperature accumulation occurs, even temperature distribution may be implemented by using the thermal pad 3 in contact with the silicon wafer 2, to avoid temperature accumulation at the local position of the silicon wafer 2, so as to improve a heat dissipation effect of the chip.

In some embodiments, a size of the thermal pad 3 is greater than a size of the silicon wafer 2. That is, when the silicon wafer 2 is disposed on the thermal pad 3, and a center of the silicon wafer 2 is aligned with a center of the thermal pad 3, the edge of the thermal pad 3 extends from an edge of the silicon wafer 2, in other words, all edges of the silicon wafer 2 are located on the thermal pad 3.

As shown in FIG. 1, the plurality of silicon wafers 2 and the plurality of thermal pads 3 are mounted in the housing 1 in the stacked manner. For example, if the bottom of the housing 1 is used as a bottom, and the upper cover of the housing 1 is used as a top, the plurality of silicon wafers 2 and the plurality of thermal pads 3 are stacked from top to bottom in the housing 1. The thermal pad 3 is mounted between the two adjacent silicon wafers 2, and the edge of the thermal pad 3 located between the two adjacent silicon wafers 2 extends from the gap between the two silicon wafers 2.

Based on the foregoing structure, the coefficient of thermal conductivity of the thermal pad 3 is greater than the coefficient of thermal conductivity of the silicon wafer 2, and therefore heat generated by the silicon wafer 2 is transferred to the thermal pad 3 in contact with the silicon wafer 2. The edge of the thermal pad 3 extends from the gap between the two adjacent silicon wafers 2, and therefore an area of the thermal pad 3 is greater than an area of the silicon wafer 2, and heat may be diffused on the thermal pad, so that the heat is evenly distributed, to avoid heat accumulation, so as to improve the heat dissipation effect of the chip.

In some embodiments, the heat on the thermal pad 3 is dissipated to the outside by using the upper cover of the housing 1. In addition, the thermal pad 3 has a relatively large heat dissipation area, and therefore the heat can be relatively quickly dissipated to the outside by using the upper cover. It may be learned that dissipation of the heat on the silicon wafer 2 may be accelerated by using the large-size thermal pad located between the two silicon wafers 2, to improve a heat dissipation capability of the chip, so as to avoid a case in which the chip is burnt out because a large amount of heat accumulates on the silicon wafer 2.

In an example, to implement electrical connection between the silicon wafers 2, correspondingly, the two adjacent silicon wafers 2 may be electrically connected by using a copper pillar. Two adjacent chips may be electrically connected by using the copper pillar. In addition, copper has relatively high thermal conductivity, and therefore the copper pillar may conduct heat to the upper cover, to dissipate the heat to the outside by using the upper cover, so as to further improve the heat dissipation capability of the chip.

There is the copper pillar between the two adjacent silicon wafers 2. To avoid the copper pillar, correspondingly, a through hole 31 configured to avoid the copper pillar is disposed on the thermal pad 3. For example, if the two adjacent silicon wafers 2 are connected by using one copper pillar, one through hole 31 is disposed on the thermal pad 3; or if the two adjacent silicon wafers 2 are connected by using a plurality of copper pillars, a plurality of through holes 31 are disposed on the thermal pad 3, as shown in FIG. 2. In this way, the thermal pad 3 is sandwiched between the two adjacent silicon wafers 2, and the copper pillar between the two adjacent silicon wafers 2 passes through the through hole 31 on the thermal pad 3.

The copper pillar that passes through the thermal pad 3 may further transfer the heat on the thermal pad 3 to the upper cover. For example, an edge of the through hole 31 on the thermal pad 3 is in contact with the copper pillar, so that the heat on the silicon wafer may reach the copper pillar through the thermal pad 3, and finally reach the upper cover of the housing through the copper column, and be dissipated to the outside by using the upper cover.

In this way, as shown in FIG. 3, the chip transfers heat upwards to the upper cover by using the copper pillar in a vertical direction, to dissipate the heat to the outside by using the upper cover. A direction indicated by a vertical arrow in FIG. 3 is a direction in which the heat is conducted by using the copper pillar. For the chip, in a horizontal direction, the coefficient of thermal conductivity of the thermal pad 3 is greater than the coefficient of thermal conductivity of the silicon wafer 2, and therefore the heat generated by the silicon wafer 2 can be relatively quickly transferred to the thermal pad 3, to reduce a temperature on the silicon wafer 2 and avoid temperature accumulation on the silicon wafer 2. A direction indicated by a horizontal arrow in FIG. 3 is a direction in which the heat is conducted to the thermal pad 3.

It may be learned that the heat generated by the silicon wafer 2 may be conducted upwards by using the copper pillar and transferred to the upper cover of the housing 1, and the heat generated by the silicon wafer 2 may be further conducted to the thermal pad 3 in contact with the silicon wafer 2. The thermal pad 3 has a relatively large area, and the heat conducted to the thermal pad 3 is diffused on the thermal pad 3, so that the heat is evenly distributed, to avoid heat accumulation. Based on all of the foregoing features of the chip, heat dissipation performance of the chip may be improved, and a case in which a relatively large amount of heat accumulates in the chip may be avoided, to protect the chip.

To improve the heat dissipation capability of the chip, correspondingly, a thermally conductive layer is filled between two adjacent thermal pads 3 and between a thermal pad 3 close to the upper cover of the housing 1 and the upper cover.

The thermally conductive layer may be made of a thermally conductive silica gel material.

In an example, the two adjacent thermal pads 3 are connected by using the thermally conductive layer, and a thermal pad 3 located at an uppermost layer is connected to the upper cover. In this way, the thermal pad 3 can relatively quickly transfer heat to the upper cover of the housing 1 by using the thermally conductive layer, to dissipate the heat to the outside by using the upper cover, so as to improve the heat dissipation capability of the chip.

To further improve the heat dissipation capability of the chip, correspondingly, in some embodiments, one or more thermal pads 3 are connected to the upper cover of the housing 1 by using a thermal conductor. The thermal conductor is a copper pillar.

In this way, the heat generated by the silicon wafer 2 may be quickly transferred to the thermal pad 3 because the coefficient of thermal conductivity of the thermal pad 3 is greater than the coefficient of thermal conductivity of the silicon wafer 2, to reduce the temperature on the silicon wafer 2. Further, the edge of the thermal pad 3 may extend from the gap between the two adjacent silicon wafers 2, and therefore the area of the thermal pad 3 is greater than the area of the silicon wafer 2, and the heat transferred to the thermal pad 3 may be diffused on the thermal pad 3 with a relatively large area, so that the heat is evenly distributed, to avoid heat accumulation on the thermal pad 3. In addition, the thermal conductor is connected between the thermal pad 3 and the upper cover, and therefore each thermal pad 3 may transfer heat upwards to the upper cover of the housing 1 by using a thermal conductor connected to the thermal pad 3, to dissipate the heat to the outside by using the upper cover of the housing 1. It may be learned that based on all of the foregoing features, the heat dissipation capability of the chip may be improved, and the heat dissipation effect of the chip may be improved.

In some embodiments, each thermal pad 3 is connected to the upper cover of the housing 1. In this way, heat absorbed by each thermal pad 3 from a silicon wafer 2 in contact with the thermal pad 3 can be quickly transferred to the upper cover, and is dissipated to the outside by using the upper cover, to improve the heat dissipation capability of the chip.

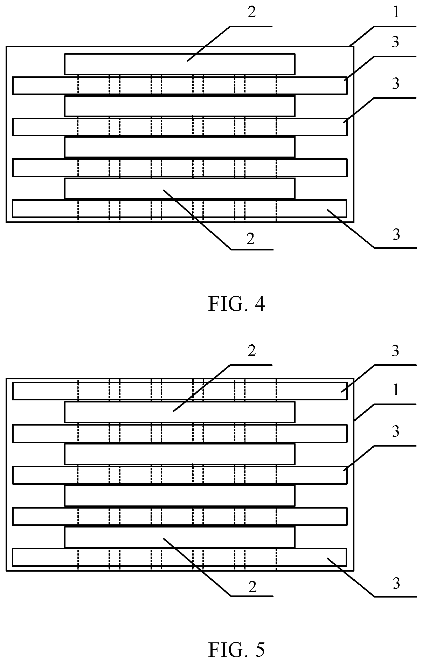

In an example, the chip dissipates heat to the outside by using the upper cover located at an upper part, and therefore to avoid temperature accumulation on a silicon wafer 2 located at the bottom, correspondingly, as shown in FIG. 4, the thermal pad 3 is mounted between the bottom of the housing 1 and the silicon wafer 2 close to the bottom, in other words, the thermal pad 3 is mounted above the silicon wafer 2 located at a lowest part of the housing 1, and the thermal pad 3 is further mounted below the silicon wafer 2. In this way, heat generated by the silicon wafer 2 located at the bottom of the housing may be transferred to the thermal pad 3 located above the silicon wafer 2, and may be further transferred to the thermal pad 3 located below the silicon wafer 2, to avoid heat accumulation on the silicon wafer 2 located at the bottom of the housing 1.

To further improve the heat dissipation capability of the chip, correspondingly, as shown in FIG. 5, the thermal pad 3 may be further mounted between the upper cover of the housing 1 and a silicon wafer 2 close to the upper cover. In this way, the thermal pad 3 located at a top can quickly transfer heat to the upper cover, to dissipate the heat to the outside by using the upper cover, and a temperature on a thermal pad 3 at a lower part can be quickly transferred to the thermal pad 3 at the top by using a copper pillar or a thermally conductive layer, to further improve the heat dissipation capability of the chip.

To accelerate dissipation of heat to the outside by the upper cover of the housing 1, correspondingly, the upper cover and the thermal pad 3 may be made of a same material. For example, each of the upper cover and the thermal pad 3 may be one or more of a single crystal diamond film, a polycrystalline diamond film, or a boron nitride film.

In addition, although the thermal pad whose size is greater than the size of the silicon wafer is added to the chip, an overall size of the chip is not increased. This is because the size of the added thermal pad is greater than the size of the silicon wafer, but is less than a size of the housing. For example, the length of the thermal pad is less than a length of the bottom of the housing, and the width of the thermal pad is less than a width of the bottom of the housing. Therefore, a length and a width of the chip are not increased even if the thermal pad is mounted between the two adjacent silicon wafers and the edge of the thermal pad extends from the gap between the two adjacent silicon wafers.

In this technology in which the thermal pad is added between the two adjacent silicon wafers, the heat dissipation capability of the chip is improved, and therefore more silicon wafers may be disposed in the chip, to improve performance of the chip.

Based on the foregoing description, a possible structure of the chip may be as follows: The thermal pad 3 is mounted between the bottom of the housing 1 of the chip and the silicon wafer 2 close to the bottom, the thermal pad 3 is mounted between the two adjacent silicon wafers 2, and the thermal pad 3 is mounted between the upper cover of the housing 1 and the silicon wafer 2 close to the upper cover. The copper pillar configured to implement electrical connection exists between the silicon wafer 2 and the substrate at the bottom of the housing, the copper pillar configured to implement electrical connection exists between the adjacent silicon wafers 2, and each thermal pad 3 is provided with the through hole configured to avoid the copper pillar. The thermally conductive layer may be further filled between the adjacent thermal pads 3, between the thermal pad 3 and the bottom of the housing, and between the thermal pad 3 and the upper cover of the housing. Each thermal pad 3 may be further connected to the upper cover of the housing 1 by using the thermal conductor.

In this way, the heat generated by the silicon wafer 2 in the housing 1 may be transferred to the upper cover of the housing by using the copper pillar, and the heat is dissipated to the outside by using the upper cover. In addition, the silicon wafer 2 may transfer the generated heat to the thermal pad 3 in contact with the silicon wafer 2, to reduce the temperature on the silicon wafer 2. The area of the thermal pad 3 is greater than the area of the silicon wafer 2, and therefore the heat transferred to the thermal pad 3 may be quickly diffused on the thermal pad 3, so that the heat is evenly distributed on the thermal pad 3, to avoid heat accumulation.

In some embodiments, the silicon wafer 2 may quickly transfer the heat to the thermal pad 3. The thermal pad 3 has a relatively large heat dissipation area because of a relatively large size of the thermal pad 3, and therefore the thermal pad 3 may quickly dissipate absorbed heat.

In addition, there is the thermally conductive layer between the thermal pads 3, and therefore the thermal pad 3 may quickly transfer the absorbed heat to the upper cover of the housing, to dissipate the heat to the outside by using the upper cover. In addition, each thermal pad 3 may be further connected to the upper cover of the housing 1 by using the thermal conductor, and therefore each thermal pad 3 may further quickly transfer the absorbed heat to the upper cover of the housing 1, to further accelerate dissipation of the heat on the thermal pad 3. It may be learned that the chip has a relatively high heat dissipation capability, and therefore heat accumulation on the silicon wafer 2 can be reduced or avoided, and accordingly a case in which the chip is burnt out due to a relatively high internal temperature may be avoided, to protect the chip.

In embodiments of this application, the chip includes the housing and the plurality of silicon wafers and the plurality of thermal pads mounted in the housing in the stacked manner, and the thermal pad is mounted between the two adjacent silicon wafers. The coefficient of thermal conductivity of the thermal pad is greater than the coefficient of thermal conductivity of the silicon wafer, and therefore the heat generated by the silicon wafer may be transferred to the thermal pad in contact with the silicon wafer, to reduce the temperature on the silicon wafer. The edge of the thermal pad extends from the gap between the two adjacent silicon wafers, and therefore the heat absorbed by the thermal pad may be diffused on the thermal pad, so that a temperature on the thermal pad is evenly distributed, to avoid heat accumulation. It may be learned that the thermal pad is mounted between the two adjacent silicon wafers, so that the heat on the silicon wafer may be quickly conducted to the thermal pad, to reduce the temperature on the silicon wafer, avoid heat accumulation, and improve the heat dissipation capability of the chip.

An embodiment of this application further provides a method for manufacturing the foregoing chip. First, a plurality of silicon wafers 2 and a plurality of thermal pads 3 may be fastened in a stacked manner. For example, the silicon wafer and the thermal pad may be fastened by using a copper pillar. At least one thermal pad 3 is mounted between two adjacent silicon wafers 2, and an edge of the thermal pad 3 extends from a gap between the two adjacent silicon wafers 2. Then, the fastened silicon wafers 2 and thermal pads 3 may be mounted in a housing 1, to obtain the chip.

Before the fastened silicon wafers 2 and thermal pads 3 are mounted in the housing 1, a thermally conductive layer may be further filled between two adjacent thermal pads 3, and a thermal conductor configured to be in contact with an upper cover of the housing 1 may be further mounted on the thermal pad 3.

As described above, the manufactured chip may include the housing and the plurality of silicon wafers and the plurality of thermal pads mounted in the housing in the stacked manner, and the thermal pad whose coefficient of thermal conductivity is greater than a coefficient of thermal conductivity of the silicon wafer is mounted between the two adjacent silicon wafers, and therefore heat generated by the silicon wafer may be transferred to the thermal pad in contact with the silicon wafer, to reduce a temperature on the silicon wafer. The edge of the thermal pad extends from the gap between the two adjacent silicon wafers, and therefore heat absorbed by the thermal pad may be diffused on the thermal pad, so that a temperature on the thermal pad is evenly distributed, to avoid heat accumulation. It may be learned that the thermal pad is mounted between the two adjacent silicon wafers, so that the heat on the silicon wafer may be quickly conducted to the thermal pad, to reduce the temperature on the silicon wafer, avoid heat accumulation, and improve a heat dissipation capability of the chip.

An embodiment of this application further provides an electronic device. The electronic device may be a mobile terminal such as a mobile phone and a tablet computer, may be a computer device, or may be another electronic device that includes a chip. The electronic device may include at least one chip described above. For example, the included chip may be a chip in a processor of the electronic device, or may be a chip in a processor of the electronic device.

As described above, the chip in the electronic device may include a housing and a plurality of silicon wafers and a plurality of thermal pads mounted in the housing in a stacked manner, and the thermal pad is mounted between two adjacent silicon wafers. A coefficient of thermal conductivity of the thermal pad is greater than a coefficient of thermal conductivity of the silicon wafer, and therefore heat generated by the silicon wafer may be quickly transferred to the thermal pad in contact with the silicon wafer, to reduce a temperature on the silicon wafer. An edge of the thermal pad may extend from a gap between the two adjacent silicon wafers, and therefore heat absorbed by the thermal pad may be diffused on the thermal pad, so that a temperature on the thermal pad is evenly distributed, to avoid heat accumulation. It may be learned that the thermal pad is mounted between the two adjacent silicon wafers, so that the heat on the silicon wafer may be quickly conducted to the thermal pad, to reduce the temperature on the silicon wafer, avoid heat accumulation, and improve a heat dissipation capability of the chip.

The foregoing descriptions are merely an embodiment of this application, but are not intended to limit this application. Any modification, equivalent replacement, or improvement made without departing from the spirit and principle of this application shall fall within the protection scope of this application.

## Claims

1. A chip, wherein the chip comprises a housing (1), a plurality of silicon wafers (2), and a plurality of thermal pads (3), wherein
the plurality of silicon wafers (2) and the plurality of thermal pads (3) are mounted in the housing (1) in a stacked manner; and
the thermal pad (3) is mounted between two adjacent silicon wafers (2), and an edge of the thermal pad (3) extends from a gap between the two adjacent silicon wafers (2).

2. The chip according to claim 1, wherein a thermally conductive layer is filled between two adjacent thermal pads (3) and between a thermal pad (3) close to an upper cover of the housing (1) and the upper cover.

3. The chip according to claim 1 or 2, wherein each thermal pad (3) is connected to the upper cover of the housing (1) by using a thermal conductor.

4. The chip according to any one of claims 1 to 3, wherein the thermal pad (3) is mounted between a bottom of the housing (1) and a silicon wafer (2) close to the bottom.

5. The chip according to claim 1, wherein the thermal pad (3) is mounted between an upper cover of the housing (1) and a silicon wafer (2) close to the upper cover.

6. The chip according to claim 1, wherein the thermal pad (3) is an insulating thermal pad.

7. The chip according to claim 1, wherein the two adjacent silicon wafers (2) are connected by using a copper pillar, and the thermal pad (3) is provided with a through hole configured to avoid the copper pillar.

8. The chip according to claim 1, wherein the upper cover of the housing (1) and the thermal pad (3) are made of a same material.

9. The chip according to any one of claims 1 to 8, wherein the thermal pad (3) is one or more of a single crystal diamond film, a polycrystalline diamond film, and a boron nitride film.

10. The chip according to any one of claims 1 to 9, wherein a size of the thermal pad (3) is greater than a size of the silicon wafer (2).

11. An electronic device, wherein the electronic device comprises at least one chip according to any one of claims 1 to 10.

12. A method for manufacturing a chip, comprising:
fastening a plurality of silicon wafers (2) and a plurality of thermal pads (3) in a stacked manner, wherein the thermal pad (3) is mounted between two adjacent silicon wafers (2), and an edge of the thermal pad (3) extends from a gap between the two adjacent silicon wafers (2); and
mounting the plurality of fastened silicon wafers (2) and the plurality of fastened thermal pads (3) in a housing (1), to obtain the chip.

13. The method according to claim 12, wherein a thermally conductive layer is filled between two adjacent thermal pads (3) and between a thermal pad (3) close to an upper cover of the housing (1) and the upper cover.

14. The method according to claim 12 or 13, wherein each thermal pad (3) is connected to the upper cover of the housing (1) by using a thermal conductor.

15. The method according to any one of claims 12 to 14, wherein the thermal pad (3) is mounted between a bottom of the housing (1) and a silicon wafer (2) close to the bottom.

16. The method according to claim 12, wherein the thermal pad (3) is mounted between an upper cover of the housing (1) and a silicon wafer (2) close to the upper cover.

17. The method according to claim 12, wherein the thermal pad (3) is an insulating thermal pad.

18. The method according to claim 12, wherein the two adjacent silicon wafers (2) are connected by using a copper pillar, and the thermal pad (3) is provided with a through hole configured to avoid the copper pillar.

19. The method according to claim 12, wherein the upper cover of the housing (1) and the thermal pad (3) are made of a same material.

20. The method according to any one of claims 12 to 19, wherein the thermal pad (3) is one or more of a single crystal diamond film, a polycrystalline diamond film, and a boron nitride film.

21. The method according to any one of claims 12 to 20, wherein a size of the thermal pad (3) is greater than a size of the silicon wafer (2).
